# EUROPÄISCHE PATENTSCHRIFT

(11) **EP 1 920 822 B1**
(45) Veröffentlichungstag und Bekanntmachung des Hinweises auf die Patenterteilung: **11.04.2012**
(21) Anmeldenummer: 07425696.7
(22) Anmeldetag: 06.11.2007
(51) Int. Cl.: B01F 7/04, B01F 13/06

(54) **Vorrichtung und Verfahren zur kontinuierlichen Mischung und Entgasung von festen und/oder flüssigen Substanzen**
Device and method for continuous mixing and degassing of solid and/or liquid substances
Dispositif et procédé destinés au mélange et au dégazage continus de substances solides et/ou liquides

(30) Priorität: 10.11.2006 IT MI20062148
(43) Veröffentlichungstag der Anmeldung: 14.05.2008
(73) Patentinhaber: Lico S.P.A., 21051 Arcisate (IT)
(72) Erfinder: Lico, Franco, 21050 Cuasso al Monte (VA) (IT)
(74) Vertreter: Jaumann, Paolo

(56) Entgegenhaltungen:
- EP-A- 0 947 540
- DE-A1- 2 328 689
- DE-A1- 4 222 695
- GB-A- 1 213 467
- US-A- 3 813 082
- US-A- 4 057 376

## Beschreibung

Die vorliegende Erfindung betrifft eine Vorrichtung und ein Verfahren zur kontinuierlichen Mischung und Entgasung von festen und/oder flüssigen Substanzen.

In zahlreichen industriellen Verfahren, wie beispielsweise bei der Zubereitung von pharmazeutischen, chemischen, Kunststoff-, Nahrungsmittel- und ähnlichen Produkten, ist es erforderlich, Komponenten in festem Zustand oder feste mit flüssigen Komponenten oder flüssige Komponenten mit flüssigen, sofern diese eine unterschiedliche Viskosität aufweisen, gleichmäßig zu vermischen.

Neben dem Mischen der Komponenten ist es bei vielen Verfahren sehr wichtig, die Gase zu beseitigen, die das Ergebnis des Verfahrens beeinträchtigen können; aus diesem Grund sind im Handel Entgasungssysteme zur Aufbereitung der Produkte bekannt.

Die bekannten Entgasertypen sind in der Lage, kontinuierliche oder diskontinuierliche Entgasungsverfahren durchzuführen. Bei den kontinuierlichen Verfahren werden die Materialien in die Entgasungsvorrichtung eingefüllt, und es kommt durch den Einsatz von Drehwellen mit Profilen in Form einer Schnecke mit konstantem oder variablem Schraubengang, welche den axialen Vorschub der Materialien bewirken, die in einen Gasansaugbereich gelangen .... Es sind Entgaser mit einer Schnecke und mit zwei Schnecken bekannt. Das Material wird vermischt und anschließend in den Bereichen, wo die schneckenförmige Welle einen größeren Durchmesser aufweist, verdichtet, wodurch das Material als Schmiermittel zwischen Schnecke und Kammer dient. Bei diesen Systemen, gleich ob sie eine oder zwei Schnecken aufweisen, erfolgt die Entgasung durch eine Öffnung auf der Oberseite der Mischkammer, welche die Drehachse enthält, wobei die Öffnung sofort nach einem Verdichtungsbereich für das Material angebracht ist, das heißt nach einem Bereich der Welle mit Schneckenprofil mit größerem Durchmesser. An diese Öffnung wird ein Luftansaugsystem angeschlossen. Wenn das Material den Verdichtungsbereich für das Material durchläuft, in dem die Welle einen größeren Durchmesser hat, trifft es auf einen Bereich der Vorrichtung, in dem die Welle einen kleineren Durchmesser hat, was zu einer geringeren Verdichtung des Materials und dem daraus resultierenden Austreten der Luft führt, die sich im Material angesammelt hat. Diese Luft wird daher vom Ansaugsystem angesaugt, das im Allgemeinen eine Ansaugpumpe umfasst.

Bei diesen bekannten Systemen beträgt die Rotationsgeschwindigkeit der Welle im Allgemeinen zwischen 10 und 100 Umdrehungen pro Minute bei Entgasern mit einer Schnecke und zwischen 100 und 2000 Umdrehungen pro Minute bei Entgasern mit zwei Schnecken.

Auf diese Weise wird ein kontinuierliches Mischverfahren erzielt, da die Substanzen entlang der Welle mit Schneckenprofil voranbewegt werden und die Entgasung, wie bereits erwähnt, in einem lokalisierten Punkt des Entgasers stattfindet.

Ein Beispiel für solche bekannte Systeme ist in Figur 1 [oder in dem Dokument US-A-3 813 082] zu erkennen, wo ein Entgaser mit einer Schnecke mit axialem Auslass dargestellt ist, bei dem die Bereiche für die Materialbeschickung und die Luftansaugung angegeben sind. Dokument US-A-3 813 082 offenbart auch eine Misch- und Entgasungsvorrichtung gemäß dem Oberbegriff des Anspruch 1.

Die Systeme bekannter Bauart können, wie bereits erwähnt, auch zwei Schnecken, das heißt zwei Schneckenprofile, aufweisen, die in der Lage sind, eine größere Materialmenge aufzubereiten. Auch bei diesen Systemen mit zwei Schnecken ist auf jeden Fall ein lokalisierter Bereich der Drehwelle vorgesehen, in dem es zur Luftansaugung kommt.

Diese Systeme bekannter Bauart weisen jedoch einige Nachteile und Beschränkungen auf.

Im Besonderen kommt es bei den Entgasungssystemen bekannter Bauart zu keiner Mischung der Komponenten, welche folglich vorher eine entsprechende Mischvorrichtung durchlaufen müssen. Auf dieses Weise ist es erforderlich, die Materialien zunächst in einem Mischer aufzubereiten und sie dann in einen Mischer von der beschriebenen Art umzufüllen, oder noch schlimmer in einen diskontinuierlichen Entgaser, was die Zeit und die Effizienz des gesamten Misch- und Entgasungsverfahrens verlängert.

Bei den Systemen bekannter Bauart ermöglicht die nach außen gerichtete Öffnung zur Gasansaugung, die, wie bereits erwähnt, auf der Höhe eines Abschnitts der Mischerwelle mit reduziertem Durchmesser angeordnet ist, die Ansaugung der Gase und daher die Entgasung der im Inneren des Mantels vorhandenen Materialien nur in einem Abschnitt des Entgasers und schränkt auf diese Weise die Effizienz des Systems ein.

Die vorrangige Aufgabe der vorliegenden Erfindung besteht darin, eine Vorrichtung anzubieten, welche die Funktionen des Mischers und des Entgasers vereint und ermöglicht, die oben angeführten Nachteile zu überwinden.

Im Bereich dieser Aufgabe besteht das Ziel der vorliegenden Erfindung darin, einen Mischer und Entgaser anzubieten, der eine kontinuierliche Durchmischung und Entgasung des Materials ermöglicht, wobei im Besonderen die Entgasung gleichzeitig im ganzen Volumen des aufbereiteten Materials stattfindet und nicht nur in jenem Volumen des Materials, das sich im Bereich einer bestimmten Zone der Entgasungskammer befindet.

Ein weiteres Ziel der vorliegenden Erfindung besteht darin, eine Misch- und Entgasungsvorrichtung mit höherer Effizienz als jene der Systeme bekannter Bauart anzubieten, welche in der Lage ist, eine größere Menge an Material pro Zeiteinheit aufzubereiten.

Ein weiteres Ziel der vorliegenden Erfindung besteht darin, eine Misch- und Entgasungsvorrichtung zur erhalten, welche mit geringen Ansaugdruckwerten im Vergleich zu den Systemen bekannter Bauart auskommt und auf diese Weise eine höhere Wirtschaftlichkeit bei der Herstellung und Wartung der Ansaugpumpe mit sich bringt.

Ein weiteres, aber nicht das letzte Ziel der vorliegenden Erfindung besteht darin, ein optimiertes Misch- und Entgasungsverfahren zu erzeugen, bei dem die Materialien trotz der hohen Rotationsgeschwindigkeiten der Welle und daher auch des Verfahrens nicht beschädigt werden.

Diese Aufgabe sowie diese und andere Ziele, die im Anschluss an die Beschreibung einer bevorzugten Ausführungsform der vorliegenden Erfindung deutlicher hervorgehen werden, werden durch eine Misch- und Entgasungsvorrichtung gemäß Anspruch 1 und ein Misch- und Entgasungsverfahren gemäß Anspruch 9 erzielt.

Weitere Merkmale und Vorteile der vorliegenden Erfindung gehen aus der nachfolgenden detaillierten Beschreibung, die als Beispiel, aber nicht als beschränkend zu betrachten ist, und den beiliegenden Figuren deutlicher hervor, wobei:

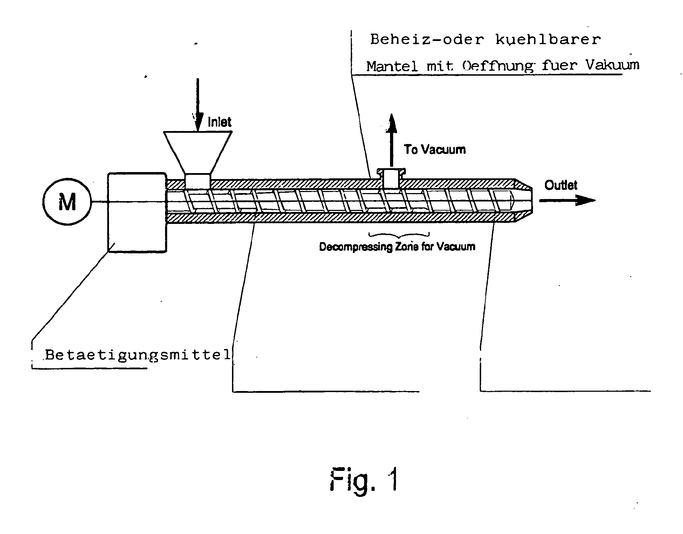

Figur 1 eine Seitenansicht in teilweisem Querschnitt einer Entgasungsvorrichtung mit einer Schnecke bekannter Bauart darstellt;
Figur 2 eine Seitenansicht in teilweisem Querschnitt mit einer vertikalen Längsebene der erfindungsgemäßen Misch- und Entgasungsvorrichtung darstellt;

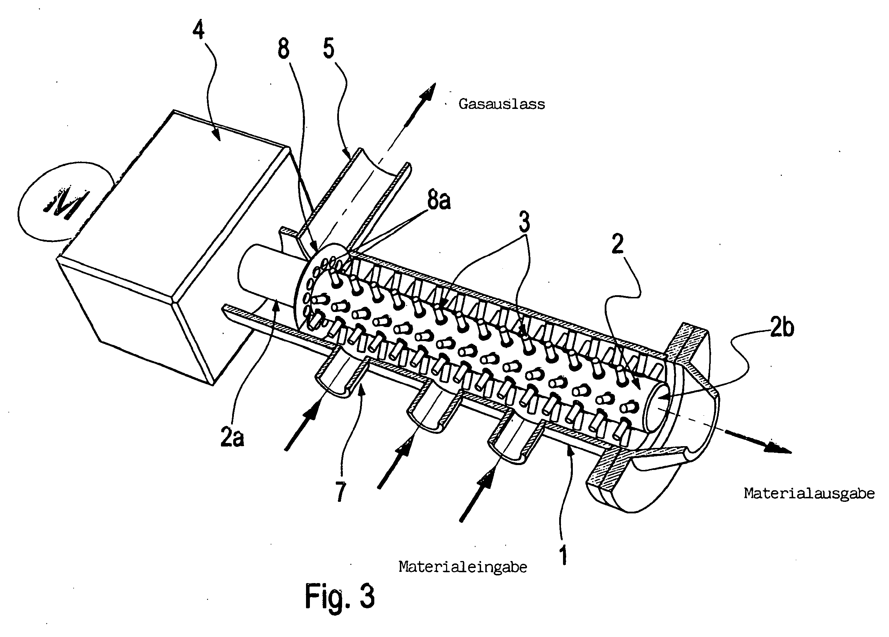

Figur 3 dieselbe Vorrichtung wie in Figur 2 in einer perspektivischen Ansicht teilweise im Querschnitt darstellt;

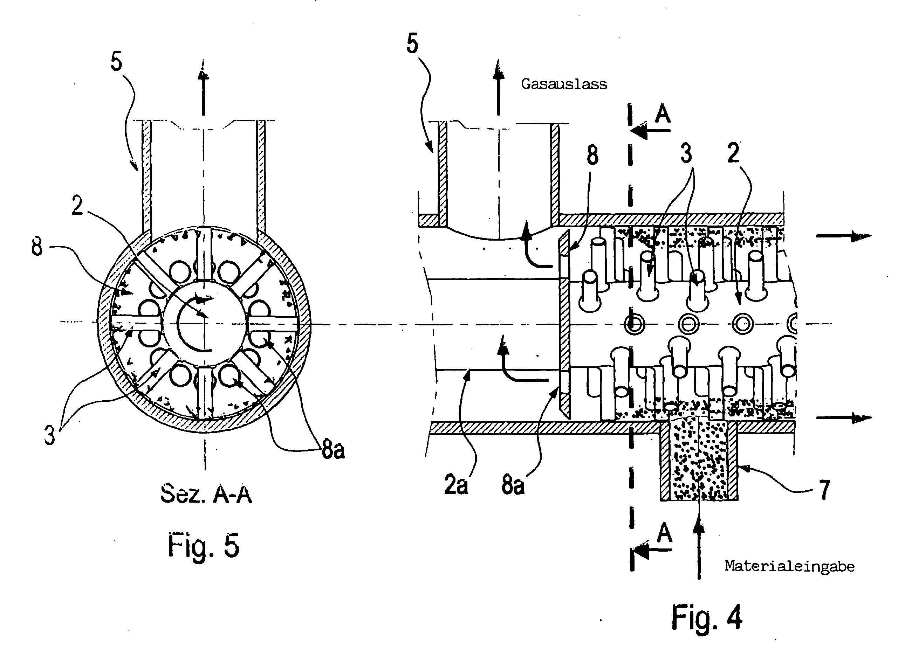

Figur 4 ein Detail der Seitenansicht in teilweisem Querschnitt von Figur 2 darstellt;
Figur 5 eine Vorderansicht im Querschnitt entlang einer Ebene A-A, die in Figur 4 angegeben ist, darstellt.

Gemäß einer Ausführungsform der vorliegenden Erfindung, die in den genannten Figuren als Beispiel dargestellt ist, umfasst die Mischvorrichtung einen Mantel 1, in dem eine Drehwelle 2 enthalten ist. Der fixe Mantel 1 kann je nach durchzuführendem Mischverfahren entweder beheizt oder gekühlt werden.

Die Drehwelle 2 ist bei der hier dargestellten Ausführungsform mit mehreren Stiften 3 versehen sind, die spiralförmig angeordnet sind. Die Konfiguration, das heißt der Schraubengang, die Länge und die Anzahl der Teilungen der Spirale, können variiert werden.

Die Drehwelle 2 weist ein erstes Ende 2a auf, das mit Betätigungsmitteln verbunden ist, die in den Figuren im Allgemeinen mit M angegeben sind, und wird im Bereich des Endes 2a von Mitteln zum Abstützen und zur Übertragung der Bewegung gehalten, die im Allgemeinen mit der Referenznummer 4 angegeben sind.

An dem im Hinblick auf das erste Ende 2a entgegengesetzten Ende endet die Drehwelle 2 mit einem zweiten Ende 2b, das frei ist. Im Bereich des zweiten Endes 2b der Welle 2 ist der Mantel 1 mit einer Öffnung zum axialen Auslass des gemischten Materials versehen, wobei unter axial entlang der Richtung der Längsachse der Welle 2 zu verstehen ist.

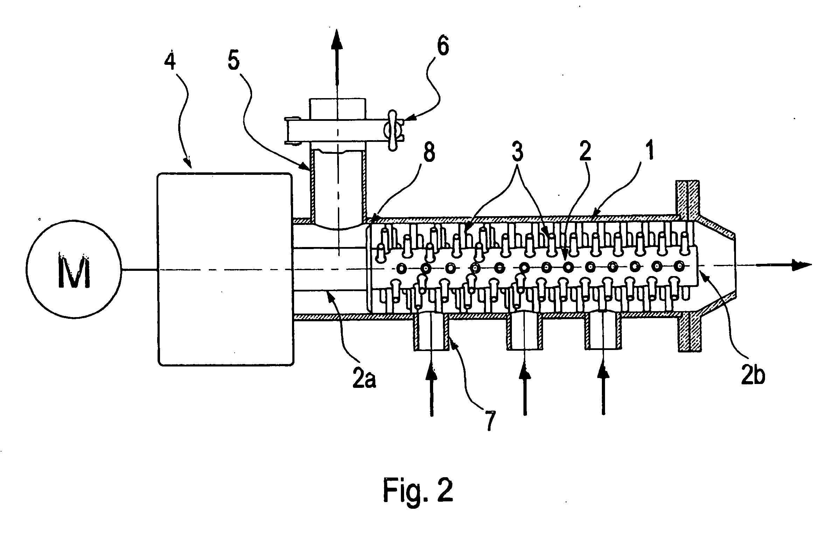

Wie beispielsweise in Figur 2 zu sehen ist, ist die erfindungsgemäße Misch- und Entgasungsvorrichtung mit Ansaugmitteln 5 versehen, die vor dem Abschnitt der Drehwelle 2 liegen, die mit Stiften 3 versehen ist, das heißt in der Nähe des ersten Endes 2a, und mit Mitteln für die Zufuhr der zu mischenden Komponenten 7, welche mehrere Anschlüsse umfassen können, die in Längsrichtung entlang der Drehwelle 2 angeordnet sind.

Gemäß der in den angeführten Figuren als Beispiel gezeigten Ausführungsform sind die Mittel für die Zufuhr der Komponenten, welche die Zufuhranschlüsse 7 umfassen, entlang dem unteren Abschnitt des Mantels 1 angeordnet, während die Mittel zur Ansaugung, die einen Ansauganschluss 5 umfassen, im Bereich des ersten Endes 2a der Drehwelle 2 angeordnet und nach oben gerichtet sind.

Diese Mittel zur Ansaugung umfassen des Weiteren eine Pumpe zum Ansaugen der Luft oder der Gase im Allgemeinen, die von der festen oder flüssigen Phase der in Mischung befindlichen Materialien getrennt werden können, wobei die Ansauganschlüsse 5 mit Ventilen 6 zur Regulierung der Gasdurchflussmenge ausgestattet sein können.

Mit diesen Anschlüssen für die Zufuhr des Materials 7 werden geeignete Mittel verbunden, welche die zu mischenden Materialien aufbereiten und dafür sorgen, dass sie in den Mantel 1 gelangen.

Unter besonderer Bezugnahme auf Figur 2 weist die erfindungsgemäße Mischvorrichtung des Weiteren Mittel zur Trennung 8 des Mischbereichs vom Luftansaugbereich auf. Die Trennmittel umfassen eine Scheibe 8, deren Außendurchmesser geeignet ist, um den Materialfluss in die Richtung der Ansaugleitung 5 zu unterbinden, und die mit radialen Öffnungen 8a in der Höhe jenes Bereichs versehen ist, in dem die Scheibe an die Welle 2 aufgepresst ist.

Die erfindungsgemäße Misch- und Entgasungsvorrichtung, wie bisher dargestellt, arbeitet folgendermaßen:

Die Betätigungsmittel M sorgen für die Drehung der Welle 2 über die Mittel zur Übertragung und zum Abstützen der Welle 4. Die zu mischenden Substanzen werden in den Mantel 1 über die Anschlüsse 7 für die Zufuhr des Materials eingeführt. Dank einer hohen Drehzahl bei der Rotation der Welle 2 werden die Materialien durch die Wirkung der Zentrifugalkraft in radialer Richtung gegen die Innenwände des Mantels 1 gedrückt. Die Mischung der Materialien erfolgt durch die kontinuierliche, wiederholte Durchmischung derselben aufgrund des Vorhandenseins der Stifte 3, welche aufgrund ihrer spiralförmigen Anordnung entlang der Welle 2 in derselben Zeit dafür sorgen, das Material zum Ende 2b der Welle 2 und damit zum offenen Ende des Mantels 1 zu bewegen, wodurch der Ausstoß des gemischten Materials ermöglicht wird.

Während der Mischphase ist die Wirkung der Zentrifugalkraft, die auf die erhöhte Drehzahl bei der Rotation der Welle 2 zurückzuführen ist, von einer Art und Weise, dass sie die in der Mischphase befindlichen Materialien in größerer Menge von den Gasen, die im Mischbereich in kleinerer Menge vorhanden sind, trennt, welche in der Nähe des Zentrums des Mantels 1, das heißt in der Nähe der Drehwelle 2, verbleiben.

An diesem Punkt ermöglicht die Betätigung der in den Figuren nicht dargestellten Ansaugmittel, welche über die Ansaugleitung 5 mit dem Mantel 1 verbunden sind, die Beseitigung der Gase aus dem Mischbereich. Das Vorhandensein von Trennmitteln 8 ermöglicht den Durchgang der Luft vom Mischbereich der Materialien in der Höhe der Welle 2 zum Luftansaugbereich in der Höhe des Ansaugrohres 5 dank des Vorhandenseins der Öffnungen 8a, während der Rückfluss der gemischten Materialien oder der in Mischung befindlichen Materialien zum Ansaugrohr 5 durch die Abdichtung der Scheibe verhindert wird. Durch die Wirkung der Zentrifugalkraft werden die Materialien nämlich gegen die Innenwände des Mantels 1 gedrückt, weit entfernt von den Öffnungen 8a, die im Innenteil der Scheibe 8 vorgesehen sind.

Die korrekte Bemessung der Welle 2 und des Mantels 1 sowie der Rotationsgeschwindigkeit der Welle 2 und der Durchflussmenge, mit der die zu mischenden Materialien in den Mantel zugeführt werden, erlaubt, dass ausschließlich gemischtes und entgastes Material ausgestoßen wird.

Auf diese Weise wird gezeigt, dass die erfindungsgemäße Misch- und Entgasungsvorrichtung ermöglicht, die Nachteile, die bei Vorrichtungen bekannter Bauart auftreten, zu überwinden und die gesteckten Ziele und Aufgaben zu erreichen.

Im Besonderen wird gezeigt, dass die erfindungsgemäße Misch- und Entgasungsvorrichtung gleichzeitig ein Misch- und Entgasungsverfahren entlang der gesamten Mischkammer ermöglicht, wodurch die Verfahrenszeiten optimiert werden.

Ein weiterer Vorteil, der durch die erfindungsgemäße Misch- und Entgasungsvorrichtung erzielt wird, besteht in den Rotationsgeschwindigkeiten der Welle, welche von ungefähr 1000 bis 5000 und mehr Umdrehungen pro Minute reichen können, was folglich eine beträchtliche Steigerung des in der Zeiteinheit behandelten Materials und daher eine beträchtliche Steigerung der Effizienz des Verfahrens im Vergleich zu den bekannten Entgasern mit sich bringt.

Außerdem wurde gezeigt, dass sowohl das Misch- als auch das Entgasungsverfahren, die von der erfindungsgemäßen Vorrichtung durchgeführt werden, kontinuierliche Verfahren sind, das heißt, dass die Materialien kontinuierlich in die Vorrichtung zugeführt werden können, wodurch das Verfahren weiterläuft und unproduktive Stillstände der Vorrichtung vermieden werden, die bei den diskontinuierlichen Systemen erforderlich sind, um die Vorrichtung mit neuem, zu mischendem Material zu beschicken.

Die erfindungsgemäße Misch- und Entgasungsvorrichtung hat den bedeutenden Vorteil, dass sie für die Entgasung relative Unterdruckwerte zwischen - 0,3 und - 0,5 Bar erfordert, Werte, die deutlich unter den circa - 1,0 Bar liegen, die für die bekannten Entgaser mit einer oder zwei Schnecken erforderlich sind.

Ein branchenkundiger Fachmann kann zahlreiche Veränderungen vornehmen, ohne dass dadurch der Schutzbereich der vorliegenden Erfindung verlassen wird.

Der Schutzbereich der Patentansprüche darf daher nicht von den Zeichnungen oder den in der Beschreibung als Beispiel angeführten bevorzugten Ausführungsformen beschränkt werden, sondern die Ansprüche müssen alle Merkmale der patentierbaren Neuheit, die aus der vorliegenden Erfindung ableitbar sind, enthalten.

## Patentansprüche

1. Misch- und Entgasungsvorrichtung mit zentrifugaler Rotation, im Wesentlichen horizontalem Vorschub des Materials und axialem Auslass, das einen Mantel (1), zumindest eine Drehwelle (2), Mittel für die Zufuhr der zu mischenden Komponenten (7) und Mittel zur Ansaugung (5) von Substanzen in gasförmigem Zustand aufweist, wobei die Drehwelle (2) zumindest einen Abschnitt aufweist, der mit mehreren Stiften (3) versehen ist, die entlang der Drehwelle (2) spiralenförmig angeordnet sind, in deren Bereich die Mischung der Komponenten durch die Wirkung der Zentrifugalkraft der Rotation erfolgt, **dadurch gekennzeichnet dass** die Ansaugmittel (5) vor dem Bereich zur Mischung der Materialien der Drehwelle (2) angeordnet sind, und **dadurch**, dass die Mittel zur Zufuhr (7) der zu mischenden Komponenten entlang des Mischbereichs der Drehwelle (2) nach den Ansaugmitteln (5) angeordnet sind, wobei die genannte Vorrichtung des Weiteren Trennmittel (8) aufweist, welche in der Lage sind, den Mischbereich der Drehwelle (2) vom Ansaugbereich zu trennen, in dessen Höhe die Ansaugmittel (5) angeordnet sind, wobei die Trennmittel eine Scheibe (8) umfassen, die an die Drehwelle (2) aufgepresst ist, mit der Drehwelle (2) fest verbunden rotiert und einen Außendurchmesser der dem Innendurchmesser des Mantels entspricht, aufweist, um den Materialfluss in Richtung des Ansaugrohrs (5) zu blockieren, wobei die Scheibe (8) des Weiteren in der Nähe zur Drehwelle (2) mit einer oder mehreren Öffnungen (8a) zum Durchgang des Gases versehen ist.

2. Misch- und Entgasungsvorrichtung nach einem beliebigen der vorhergehenden Anspruche, **dadurch gekennzeichnet, dass** die Drehwelle (2) ein erstes Ende (2a) aufweist, das mit Mitteln zum Abstützen und zur Übertragung der Bewegung (4) verbunden ist, die ihrerseits mit Betätigungsmitteln (M) verbunden sind, und ein zweites Ende (2b), das frei ist und in dessen Nähe der Mantel (1) nach außen geöffnet ist, um den axialen Auslass des Materials zu ermöglichen.

3. Misch- und Entgasungsvorrichtung nach einem beliebigen der vorhergehenden Ansprüche, **dadurch gekennzeichnet, dass** die Ansaugmittel einen oder mehrere Ansauganschlüsse (5) aufweisen, die auf dem Mantel (1) in der Höhe des ersten Endes (2a) der Drehwelle (2) angeordnet sind.

4. Misch- und Entgasungsvorrichtung nach einem beliebigen der vorhergehenden Ansprüche, **dadurch gekennzeichnet, dass** die Ansaugmittel des Weiteren eine Pumpe zum Ansaugen der Gase aufweisen.

5. Misch- und Entgasungsvorrichtung nach einem beliebigen der vorhergehenden Ansprüche, **dadurch gekennzeichnet, dass** die Mittel für die Zufuhr der zu mischenden Komponenten einen oder mehrere Anschlüsse für die Zufuhr der Komponenten (7) aufweisen.

6. Misch- und Entgasungsvorrichtung nach vorhergehendem Anspruch, **dadurch gekennzeichnet, dass** die Zufuhranschlüsse (7) entlang des Mischbereichs der Drehwelle (2) angeordnet sind.

7. Misch- und Entgasungsvorrichtung nach vorhergehendem Anspruch, **dadurch gekennzeichnet, dass** die Zufuhranschlüsse (7) die Zufuhr des Materials in den Mantel (1) von unten ermöglichen.

8. Misch- und Entgasungsvorrichtung nach einem beliebigen der vorhergehenden Ansprüche, **dadurch gekennzeichnet, dass** der Mantel (1) auf unterschiedliche Temperaturen erwärmt oder abgekühlt werden kann.

9. Misch- und Entgasungsverfahren für feste Produkte oder für feste und flüssige Produkte oder für flüssige mit flüssigen Produkten, das durch eine Misch- und Entgasungsvorrichtung nach einem beliebigen der vorhergehenden Ansprüche erzeugt wird, wobei die Mischung und Entgasung kontinuierlich erfolgen, wobei die Mischung durch die Zentrifugalwirkung aufgrund der Rotation einer Drehwelle (2) erfolgt und die Entgasung gleichzeitig durch die Wirkung eines negativen Werts des relativen Drucks erfolgt, der im gesamten Innenvolumen zumindest im Abschnitt des die Drehwelle (2) enthaltenden Mantels (1) erzeugt wird, wo der Mischvorgang stattfindet.

10. Misch- und Entgasungsverfahren für feste Produkte oder für feste und flüssige Produkte oder für flüssige mit flüssigen Produkten nach dem vorhergehenden Anspruch, **dadurch gekennzeichnet, dass** es folgende Phasen umfasst:
- Vorbereitung einer Misch- und Entgasungsvorrichtung nach einem beliebigen der vorhergehenden Ansprüche von 1 bis 8;
- Versetzen der Drehwelle(2)in eine Rotationsbewegung;
- Zufuhr der zu mischenden Komponenten in die Vorrichtung;
- Betätigung der Ansaugmittel (5), wodurch die Entgasung kontinuierlich und entlang der gesamten Länge des Mischbereichs des Mantels (1) erfolgt.

## Claims

1. A device for mixing and degassing with centrifugal rotation, with essentially horizontal material feeding and axial discharge, which has a coating (1), at least one rotation shaft (2), elements for supplying the components (7) to be mixed and elements for the uptake (5) of substances in the gaseous state, in which the rotation shaft (2) features at least one section provided with a plurality of pins (3), which are arranged along the rotation shaft (2) in a spiral fashion, in whose area the mixing of the components takes place due to the centrifugal force of rotation, **characterised by** the fact that the intake elements (5) are arranged upstream of the material mixing area of the rotation shaft (2), and **characterised by** the fact that the elements for the supply (7) of the components to be mixed along the mixing area of the rotation shaft (2) are arranged downstream of the intake means (5), in which the aforesaid device further comprises separator elements (8) which are capable of separating the mixing area of the rotation shaft (2) from the intake area, level with which the intake elements (5) are arranged, wherein the separator means comprise a disc (8) which is applied by pressure to the rotation shaft (2) and which rotates, connected in a fixed manner, with the rotation shaft (2) and features an external diameter that corresponds with the internal diameter of the coating, in order to block the flow of material in the direction of the intake tube (5), wherein the disc (8) is also equipped, in the vicinity of the rotation shaft (2), with one or a plurality of openings (8a) for the passage of the gas.

2. A device for mixing and degassing according to the previous claim, **characterised by** the fact that the rotation shaft (2) features a first end (2a) which is connected to elements for support and for the transmission of motion (4), which are in turn connected to activation elements (M), and a second end (2b), which is free and in proximity to which the coating (1) is open towards the outside in order to allow the axial discharge of the material.

3. A device for mixing and degassing according to any one of the previous claims, **characterised by** the fact that the intake elements feature one or a plurality of intake attachments (5), which are arranged on the coating (1) level with the first end (2a) of the rotation shaft(2).

4. A device for mixing and degassing according to any one of the previous claims, **characterised by** the fact that the intake elements also feature a pump for intake of gases.

5. A device for mixing and degassing according to any one of the previous claims, **characterised by** the fact that the elements for supplying the components to be mixed feature one or a plurality of connectors for the supply of the components (7).

6. A device for mixing and degassing according to the previous claim, **characterised by** the fact that the supply connectors (7) are arranged along the mixing area of the rotation shaft (2).

7. A device for mixing and degassing according to the previous claim, **characterised by** the fact that the supply connectors (7) allow the material to be supplied to the coating (1) from underneath.

8. A device for mixing and degassing according to any one of the previous claims, **characterised by** the fact that the coating (1) can be heated or cooled to different temperatures.

9. A method for mixing and degassing solid products, or solid and liquid products, or liquids with liquid products, obtained by means of a device for mixing and degassing according to any one of the previous claims, wherein the mixing and degassing take place in a continuous fashion, wherein the mixing takes place by means of the centrifugal effect of the rotation of a rotating shaft (2) and the degassing takes place simultaneously by means of the effect of a negative value of the relative pressure which is generated throughout the internal volume, at least in the section of coating (1) containing the rotation shaft (2), where the mixing takes place.

10. A method for mixing and degassing for solid products or for solid and liquid products or for liquids with liquid products according to the previous claim, **characterised by** the fact that the said method comprises the following steps:
- Preparation of a device for mixing and degassing according to any one of the previous claims from 1 to 8;
- Movement of the rotation shaft (2) in a rotary motion;
- Supply of components to be mixed in the device;
- activation of the intake elements (5), whereby the degassing takes place continuously and along the entire length of the mixing area of the coating (1).

## Revendications

1. Dispositif de malaxage et de dégazage avec rotation centrifuge, avec avance du matériel essentiellement horizontal et déchargement axial, qui présente un revêtement (1), au moins un arbre de rotation (2), des éléments pour l'alimentation des composants (7) à mélanger et des éléments pour l'aspiration (5) de substances à l'état gazeux, dont l'arbre de rotation (2) présente au moins une section équipée d'une pluralité d'axes (3), disposés le long de l'arbre de rotation (2) décrivant une spirale, dans ladite zone se produisant le malaxage des composants sous l'effet de la force centrifuge de la rotation, **caractérisé par le fait que** les éléments d'aspiration (5) sont disposés en amont de la zone pour le malaxage du matériel de l'arbre de rotation (2), et **caractérisé par le fait que** les éléments pour l'alimentation (7) des composants à mélanger le long de la zone de malaxage de l'arbre de rotation (2) sont disposés en aval des moyens d'aspiration (5), dont le dispositif mentionné comprend également des éléments séparateurs (8) en mesure de séparer la zone de malaxage de l'arbre de rotation (2) à partir de la zone d'aspiration, au niveau de laquelle sont disposés les éléments d'aspiration (5), dont les moyens séparateurs comprennent un disque (8) qui est appliqué à pression sur l'arbre de rotation (2) et qui tourne, raccordé de façon fixe, avec l'arbre de rotation (2) et présente un diamètre externe qui correspond au diamètre interne du revêtement, dans le but de bloquer le flux de matériel en direction du tube d'aspiration (5), dont le disque (8) est également muni, à proximité de l'arbre de rotation (2), d'une ou plusieurs ouvertures (8a) pour le passage du gaz.

2. Dispositif de malaxage et de dégazage selon une des revendications précédentes, **caractérisé par le fait que** l'arbre de rotation (2) présente une première extrémité (2a) qui est raccordée à des éléments pour le support et pour la transmission du mouvement (4), qui sont, à leur tour, raccordés à des éléments d'activation (M), et une deuxième extrémité (2b) libre et à proximité de laquelle le revêtement (1) est ouvert vers l'extérieur dans le but de permettre le déchargement axial du matériel.

3. Dispositif de malaxage et dégazage selon une des revendications précédentes, **caractérisé par le fait que** les éléments d'aspiration présentent un ou plusieurs raccords d'aspiration (5), disposés sur le revêtement (1) au niveau de la première extrémité (2a) de l'arbre de rotation (2).

4. Dispositif de malaxage et de dégazage selon une des revendications précédentes, **caractérisé par le fait que** les éléments d'aspiration présentent également une pompe pour l'aspiration des gaz.

5. Dispositif de malaxage et de dégazage selon une des revendications précédentes, **caractérisé par le fait que** les éléments pour l'alimentation des composants à mélanger présentent un ou une pluralité de raccords pour l'alimentation des composants (7).

6. Dispositif de malaxage et de dégazage selon la revendication précédente, **caractérisé par le fait que** les raccords d'alimentation (7) sont disposés le long de la zone de malaxage de l'arbre de rotation (2).

7. Dispositif de malaxage et de dégazage selon la revendication précédente, **caractérisé par le fait que** les raccords d'alimentation (7) permettent l'alimentation du matériel dans le revêtement (1) par le bas.

8. Dispositif de malaxage et de dégazage selon une des revendications précédentes, **caractérisé par le fait que** le revêtement (1) peut être chauffé ou refroidi à différentes températures.

9. Procédé de malaxage et de dégazage pour des produits solides ou pour des produits solides et liquides ou pour des liquides avec des produits liquides, obtenu par l'intermédiaire d'un dispositif de malaxage et de dégazage selon une des revendications précédentes, où le malaxage et le dégazage se produisent en continu, où le malaxage se produit par un effet centrifuge grâce à la rotation d'un arbre de rotation (2) et le dégazage a lieu simultanément sous l'effet d'une valeur négative de la pression relative qui est générée dans l'ensemble du volume interne au moins dans la section du revêtement (1) contenant l'arbre de rotation (2), où a lieu le procédé de malaxage.

10. Procédé de malaxage et de dégazage pour des produits solides ou pour des produits solides et liquides ou pour des liquides avec des produits liquides selon la revendication précédente, **caractérisé par le fait qu'**il comprend les phases suivantes :
- préparation d'un dispositif de malaxage et de dégazage selon une des revendications précédentes de 1 à 8;
- actionnement de l'arbre de rotation (2) en mouvement rotatoire ;
- alimentation des composants à mélanger dans le dispositif ;
- activation des éléments d'aspiration (5), faisant en sorte que le dégazage se produit de faon continue et sur toute la longueur de la zone de malaxage du revêtement (1).
